Europäisches Patentamt

European Patent Office

Office européen des brevets

(19)

(11) Numéro de publication : **0 159 279**
**B1**

(12) # FASCICULE DE BREVET EUROPÉEN

(45) Date de publication du fascicule du brevet :
07.06.89

(51) Int. Cl.⁴ : **G 01 R 29/08**

(21) Numéro de dépôt : 85440017.3

(22) Date de dépôt : 13.03.85

(54) **Procédé de contrôle d'adaptation d'impédance dans les chaînes de réception faible bruit et thermomètre micro-onde miniature de mise en oeuvre du procédé.**

(30) Priorité : 21.03.84 FR 8404792

(43) Date de publication de la demande :
23.10.85 Bulletin 85/43

(45) Mention de la délivrance du brevet :
07.06.89 Bulletin 89/23

(84) Etats contractants désignés :
DE GB NL

(56) Documents cités :
FR-A- 2 415 799
FR-A- 2 497 947
NACHRICHTEN ELEKTRONIK, vol. 35, no. 11, novembre 1981, pages 428-434, Heidelberg, DE; G. EVERS: "Radiometer-Empfänger"
ELECTRONIC LETTERS, vol. 14, no. 16, mars 1978, pages 194-195, Hitchin, Herts., GB; K.M. LÜDEKE et al.: "Radiation balance microwave thermograph for industrial and medical applications"

(73) Titulaire : **CENTRE NATIONAL DE LA RECHERCHE SCIENTIFIQUE (CNRS)**
**15, Quai Anatole France**
**F-75007 Paris (FR)**

(72) Inventeur : **Constant, Eugène**
**39 Avenue du Vieux Château**
**F-59650 Villeneuve d'Asco (Nord) (FR)**
Inventeur : **Leroy, Yves**
**80 rue Gaston Baratte**
**F-59650 Villeneuve d'Asco (Nord) (FR)**
Inventeur : **van de Velde, Jean-Claude**
**Résidence de l'Europe- OU/233**
**F-59370 Mons-en-Baroeul (Nord) (FR)**

(74) Mandataire : **Lepage, Jean-Pierre**
**Cabinet Lepage & Aubertin Innovations et Prestations 23/25, rue Nicolas Leblanc B.P. 1069**
**F-59011 Lille Cédex 1 (Nord) (FR)**

EP 0 159 279 B1

Jouve, 18, rue St-Denis, 75001 Paris, France

## Description

L'invention est relative à un procédé d'étalonnage et de contrôle d'adaptation d'impédance pour chaînes de réception faible bruit pour dispositif de mesure de bruit micro-onde. L'invention trouvera particulièrement son application en thermographie micro-onde réalisé en circuit intégré monolithique pour la mesure de température interne de corps.

Le principe du thermographe micro-onde pour la mesure en profondeur, de l'ordre de quelques centimètres, de température, est bien connu. Il s'agit d'un appareil comprenant notamment une antenne destinée à capter le rayonnement thermique émis par un certain volume du corps à examiner.

Il est connu qu'il existe une relation directe entre le signal micro-onde émis et la température interne du corps.

Plusieurs dispositifs de ce type ont été mis au point tel que le radiomètre de Dicke pour permettre d'analyser le rayonnement thermique.

En général, le principe utilisé peut être résumé de la façon suivante. Le signal hyperfréquence capté par l'antenne résultant du rayonnement thermique de l'objet à analyser, qui est proportionnel à la température dudit objet, est comparé alternativement à un signal provenant d'une résistance de bruit étalon de température constamment contrôlée et mesurée.

A cet effet, un commutateur commandé par un signal BF alternatif permet de « brancher » alternativement à l'entrée d'un amplificateur hyperfréquence le signal provenant de la résistance de bruit ou celui provenant de l'antenne hyperfréquence.

Le signal alternatif reçu et détecté à la sortie de l'amplificateur est ainsi proportionnel à la différence de température entre celle de l'objet à mesure et celle de la source de bruit. Ce signal peut donc constituer un signal d'erreur permettant d'ajuster le réglage de la température de la résistance de bruit étalon de façon à obtenir l'égalité des deux températures. Il suffit alors de lire la température de la résistance étalon de bruit pour obtenir celle de l'objet à mesurer.

Il faut toutefois noter que pour obtenir une mesure précise de la température de l'objet, il est nécessaire de connaître avec exactitude l'impédance présentée par l'antenne captant le rayonnement thermique et d'ajuster de façon rigoureuse celle de la résistance de bruit dont la température devra être réglée et contrôlée de façon rigoureuse.

En effet, la température de bruit de l'amplificateur dépend de l'impédance du dispositif d'entrée et il est donc essentiel que la résistance de l'antenne soit égale à celle de la résistance de bruit.

A l'heure actuelle, cette mesure est extrêmement délicate et nécessite une manipulation préalable particulièrement fastidieuse.

A cet égard, il est connu du document FR-A-2 415 799 un dispositif pour la mesure de la température physique d'un objet à l'aide de micro-onde qui utilise un radiomètre de Dicke et une antenne orientée sur l'objet.

Ce dispositif est basé sur une méthode de zéro traditionnelle et on récupère le bruit au moyen de l'antenne puis on compare ce bruit à une référence. Après stabilisation, on conclut que la valeur de la référence correspond à la valeur de la température de l'objet considéré.

Cependant, un tel dispositif présente les inconvénients précités.

Le but de la présente invention est de présenter un procédé de contrôle d'adaptation d'impédance pour chaîne de réception faible bruit telle que les radiomètres utilisés en thermographie micro-onde qui permet de s'assurer à tout instant de la correspondance exacte entre l'impédance présentée par l'antenne et l'impédance présentée par la source de bruit étalon.

Selon l'invention, la comparaison des impédances est réalisée en permanence tout au long de l'expérience, il en résulte une grande fiabilité des résultats de la mesure.

Par ailleurs, selon un mode préférentiel de mise en œuvre du procédé de l'invention, en cas de variation d'une impédance par rapport à l'autre, le circuit électrique de mise en œuvre du procédé ajuste immédiatement l'impédance présentée par la source étalon de bruit afin d'ajuster cette dernière par rapport à l'impédance de l'antenne.

Il en résulte une grande simplification d'utilisation pour le manipulateur qui n'a plus à se préoccuper au cours de l'expérience de l'adaptation des différentes impédances, celles-ci étant corrigées automatiquement.

Il faut par ailleurs souligner que si, par erreur, l'antenne de réception du rayonnement thermique était mal disposée et que celle-ci présentait une impédance mal adaptée, le manipulateur pourrait en être immédiatement averti et effectuer les réglages qui s'imposent.

Un autre but de la présente invention est de présenter un thermomètre micro-onde miniature pour la mise en œuvre du procédé de la présente invention. Ce thermomètre miniature se présente sous la forme d'un circuit intégré monolithique et par conséquent il bénéficie d'un encombrement extrêmement réduit.

Par ailleurs, l'ensemble des composants y compris l'antenne auront pu être concentrés sur un même circuit grâce à une mise en œuvre technologique particulière.

En outre, l'amplificateur hyperfréquence utilisé jouit d'une architecture de fabrication spéciale qui lui permet de bénéficier d'une très large bande passante avec une fréquence de coupure largement augmentée vis-à-vis des réalisations traditionnelles.

D'autres buts et avantages de la présente invention apparaîtront au cours de la description qui va suivre qui n'est cependant donnée qu'à titre indicatif et qui n'a pas pour but de la limiter.

Selon la présente invention, le procédé d'étalonnage et de contrôle d'adaptation d'impédance pour chaînes de réception faible bruit, trouvant notamment son application en thermographie micro-onde pour la mesure de température interne d'un corps, procédé dans lequel :

on capte le rayonnement thermique du corps à examiner à l'aide d'une antenne,

on compare le signal reçu par l'antenne avec le signal émis par une source de bruit étalon, ajustable en température, est caractérisé en ce que :

on dirige les signaux reçus par l'antenne et les signaux issus de la source de bruit étalon alternativement vers l'entrée d'un amplificateur à travers des moyens de commutation, pilotés par une fréquence $F_0$,

on place, à l'entrée de l'amplificateur, alternativement et périodiquement à une fréquence $F_1$, une impédance additionnelle en parallèle soit avec l'antenne, soit avec la source de bruit étalon, la fréquence $F_1$ étant nettement supérieure à la fréquence $F_0$,

on compare l'influence exercée par l'impédance additionnelle sur l'antenne, et sur la source de bruit étalon, en détectant la modification du signal d'entrée de l'amplificateur et en analysant l'écart des impédances respectivement présentées par l'antenne et la source de bruit étalon,

on ajuste, en adaptant leur impédance, soit l'antenne, soit la source de bruit pour égaliser ces influences et par voie de conséquence égaliser les impédances présentées par l'antenne et la source de bruit étalon.

Le dispositif de mesure de bruit micro-onde mettant en œuvre le procédé de la présente invention comprend au moins :

une antenne, apte à capter le rayonnement micro-onde, et à délivrer un signal de sortie correspondant,

une source de buit étalon, ajustable en température via un circuit de commande de chauffage, apte à délivrer un signal correspondant à la température de ladite source,

des moyens de commutation, pilotés par une fréquence $F_0$, dont les entrées sont reliées respectivement à ladite antenne et à ladite source de bruit étalon et délivrant un signal de sortie,

un amplificateur, dont l'entrée est au moins connectée à la sortie desdits moyens de commutation, délivrant en sortie un signal d'amplitude correspondant à la différence de niveau entre lesdits signaux délivrés respectivement par l'antenne et par la source de bruit étalon,

une impédance additionnelle, apte à être placée périodiquement sur l'entrée de l'amplificateur en parallèle avec l'impédance présentée soit par l'antenne, soit par la source de bruit à l'entrée de l'amplificateur,

des moyens de contrôle d'adaptation d'impédance, pilotés à une fréquence $F_1$ nettement supérieure à ladite fréquence $F_0$, aptes au moins soit à placer ladite impédance à l'entrée de l'amplificateur, soit se placer en circuit ouvert,

des moyens pour analyser l'écart des impédances présentées par l'antenne et la source de bruit étalon et pour ajuster, en adaptant leur impédance, soit l'antenne, soit la source de bruit, pour égaliser les influences exercées par l'impédance additionnelle sur l'antenne et sur la source de buit, et par voie de conséquence pour égaliser les impédances présentées par l'antenne et la source de bruit étalon.

L'invention sera mieux comprise à la lecture de la description suivante accompagnée de dessins en annexe parmi lesquels :

la figure 1 schématise le principe de fonctionnement d'un circuit de contrôle d'adaptation d'impédance pour chaîne de réception faible bruit selon une mise en œuvre du procédé de la présente invention,

la figure 2 schématise le circuit du thermomètre micro-onde de la présente invention,

la figure 3 représente l'architecture interne du circuit intégré utilisé pour la réalisation du thermomètre micro-onde miniature selon la présente invention.

La présente invention vise un procédé de contrôle d'adaptation d'impédance pour chaîne de réception faible bruit et un thermomètre micro-onde miniature. La description du procédé est appliquée à la thermographie micro-onde néanmoins, l'invention pourra être appliquée à tout dispositif de mesure utilisant comme principe d'analyse la comparaison des signaux émis par une source de référence et la source à étudier.

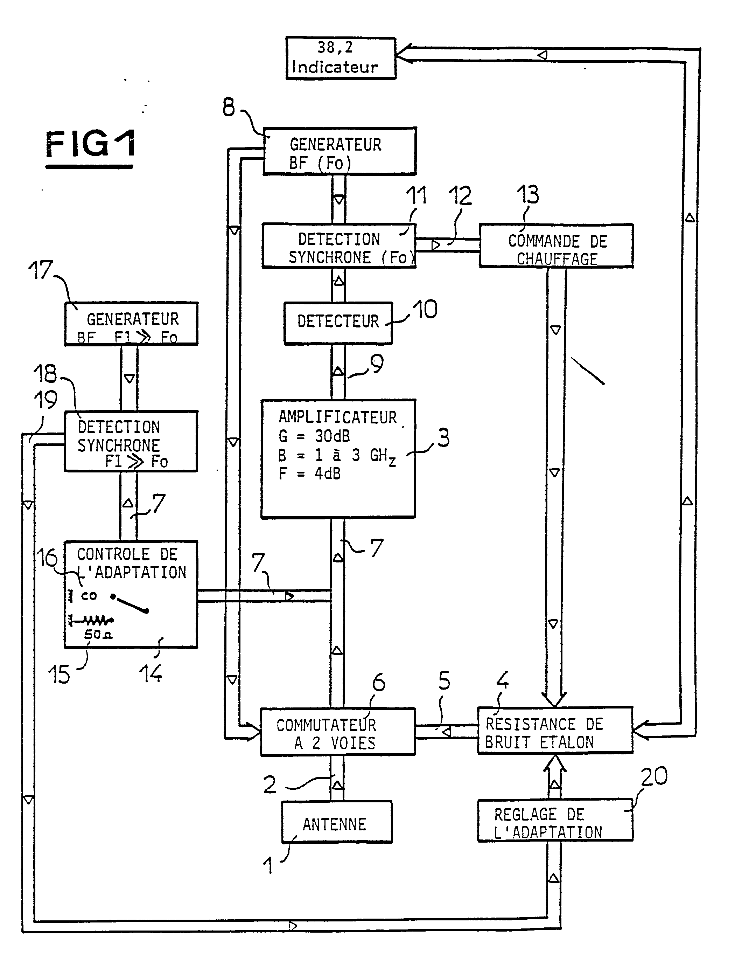

La figure 1 schématise le diagramme de fonctionnement d'un radiomètre de thermographie micro-onde.

La mesure de la température interne d'un corps non illustré est réalisée au moyen d'une antenne 1 plaquée sur ledit corps et qui capte le rayonnement thermique émis par ledit corps.

Ce rayonnement thermique est proportionnel à la température du corps et par ailleurs l'antenne capte les signaux émis selon un certain volume qui correspond à une partie interne du corps, ce qui permet d'effectuer une mesure en profondeur de l'ordre de quelques centimètres de la température.

Les signaux 2 captés par l'antenne sont dirigés vers un amplificateur 3. Par ailleurs, une source de bruit étalon 4 généralement constituée par une résistance délivre également un signal 5 proportionnel à la température de ladite source 4.

La source 4 est également connectée à un indicateur, tel que le montre la figure 1, qui affiche la température.

Ce signal 5 est dirigé également vers l'amplificateur 3 via un commutateur à deux voies 6 qui, alternativement, branche l'entrée 7 de l'amplificateur 3 vers l'antenne 1 ou vers la source de bruit 4 de sorte tantôt à alimenter l'amplificateur avec le signal 2, tantôt avec le signal 5.

Le commutateur à deux voies 6 est piloté par un générateur BF 8 qui délivre une fréquence $F_0$ au commutateur 6.

De la sorte, en sortie 9 d'amplificateur, on obtient un signal dont l'amplitude est proportionnelle à la différence de niveau présentée par les signaux 2 délivrés par l'antenne et les signaux 5 délivrés par la résistance étalon de bruit 4.

Le signal 9 en sortie d'amplificateur 3 est dirigé vers un détecteur 10 qui indique au manipulateur s'il y a égalité entre les températures mesurées par l'antenne 1 et la température de la source étalon 4. Il apparaît ainsi que le signal 9 en sortie d'amplificateur correspond à un signal « d'erreur » que l'opérateur doit tenter d'annuler en ajustant le chauffage de la résistance de bruit étalon 4 pour égaliser celle-ci avec la température du corps dont on capte le rayonnement thermique à l'aide de l'antenne 1.

Il est possible d'améliorer le procédé décrit précédemment en disposant en sortie de détecteur 10, un détecteur synchrone 11 de fréquence $F_0$ pilotée par le générateur BF 8. Le détecteur synchrone 11 délivre un signal 12 directement proportionnel à l'écart de température présenté entre le corps examiné et la résistance de bruit étalon qui permet à l'aide d'un circuit de commande de chauffage 13 d'ajuster la température de la résistance de bruit étalon 4 pour obtenir un signal d'erreur 9 nul.

Il faut toutefois noter qu'une mesure précise de la température du corps examiné nécessite une connaissance exacte de l'adaptation ou de l'impédance présentée par l'antenne 1 captant le rayonnement thermique émis par ledit corps.

En effet, la température de bruit de l'amplificateur dépend de l'impédance du dispositif d'entrée et il est donc essentiel que la résistance de l'antenne soit égale à celle de la résistance de bruit. A la mise en œuvre du procédé de la présente invention, il est possible de contrôler en permanence cette égalité.

Selon le procédé de la présente invention, on place alternativement en parallèle tantôt avec l'antenne 1, tantôt avec la source étalon 4, une impédance additionnelle et l'on compare l'influence exercée par l'impédance additionnelle sur l'antenne et sur la source de bruit de sorte à ajuster l'antenne ou la source de bruit pour égaliser ces influences et par voie de conséquence les impédances présentées par l'antenne et la résistance de bruit étalon 4.

Selon l'invention, on place à l'entrée de l'amplificateur 3 un circuit de contrôle d'adaptation d'impédance 14 qui tantôt place une impédance 15 à l'entrée de l'amplificateur 3 tantôt se place en circuit ouvert 16. Donc périodiquement, on vient placer une impédance additionnelle 15 à l'entrée de l'amplificateur 3. Le circuit de contrôle de l'impédance est piloté par un générateur BF 17 qui délivre un signal de fréquence F1 qui assure la commutation de l'impédance 15 et du circuit ouvert 16.

La mise en place d'une impédance additionnelle périodique aux bornes d'entrée de l'amplificateur 3 a pour conséquence immédiate de modifier le signal d'entrée 7 de l'amplificateur.

Ce signal d'entrée 7 est analysé par un détecteur synchrone 18, piloté par le générateur BF 17, qui délivre un signal 19.

Pour le bon fonctionnement du procédé, il faut noter qu'il est souhaitable que la fréquence $F_1$ soit nettement supérieure à la fréquence $F_0$ délivré par le générateur 8.

Le signal 19 est directement porportionnel à l'écart des impédances présentées par l'antenne 1 et la résistance de bruit étalon 4. Par conséquent, ce signal 19, pour optimiser le procédé, pourra être dirigé vers un circuit de réglage 20 de l'adaptation d'impédance présentée par la résistance étalon de bruit 4 de sorte à ajuster cette dernière avec celle présentée par l'antenne 1.

Le circuit de contrôle d'adaptation 14 se présente comme un commutateur commandé par une tension alternative de fréquence F1 qui permet de mettre alternativement en parallèle sur l'entrée de l'amplificateur hyperfréquence 3 une capacité ou une résistance additionnelle. On modifie ainsi alternativement l'impédance d'entrée vue par l'amplificateur dont la température de bruit $T_R$ mais il faut noter que cette modification d'impédance ou de la température de bruit $T_R$ ne sera pas forcément la même suivant que l'antenne ou la résistance de bruit est branchée à l'entrée de l'ampli et ce n'est que dans le cas où la résistance de bruit 4 et l'antenne 1 présentent la même impédance que la modification d'impédance sera identique. Il suffit donc de détecter à la sortie de l'amplificateur le signal alternatif de fréquence F1 pour obtenir un signal d'erreur proportionnel à la différence d'impédance entre la résistance de bruit 4 et celle de l'antenne 1. Le signal d'erreur peut ensuite être utilisé pour modifier la valeur de la résistance de bruit afin qu'elle demeure égale à celle de l'antenne ou plus simplement lorsqu'il est au-delà d'un certain seuil pour envoyer un message à l'expérimentateur indiquant que l'antenne est mal adaptée.

Ce procédé de contrôle d'adaptation d'impédance qui peut être appliqué à toute chaîne de réception faible bruit a été repris pour la fabrication d'un thermomètre micro-onde miniature selon l'invention.

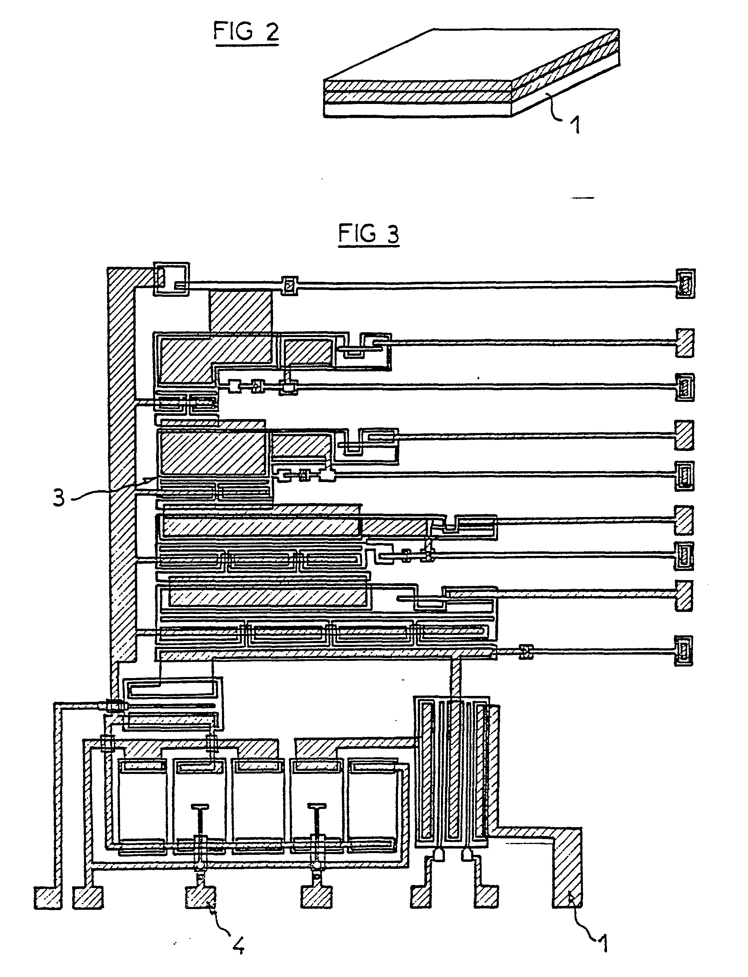

Le thermomètre micro-onde miniature est réalisé selon des schémas illustrés aux figures 2 et 3. Il s'agit d'un thermomètre réalisé à circuit intégré en technologie monolithique qui utilise les couches épitaxiées n + n sur semi isolant réalisé en semi-conducteur du type III-V tel que par exemple en AsGa.

L'antenne 1 est plaquée à la partie inférieure du circuit. L'ensemble est ainsi conçu de façon intégrée.

L'élément actif de base est constitué de transistors à effet de champ utilisant une grille à contact Schottky.

La réalisation de la résistance formant la source de bruit étalon se fera de préférence sous forme planar constituée d'une couche épitaxiée entre deux contacts ohmiques.

La commande de chauffage 13 qui permet de modifier la température de la source de bruit étalon 4 est réalisée de préférence au moyen de résistances chauffantes encadrant ou disposées à proximité immédiate de la résistance de bruit. La distance sera de l'ordre de quelques microns.

Le dispositif de mesure de la température de la source de bruit étalon 4 utilise les variations, en fonction de la température, de la caractéristique courant tension d'un contact métal semi-conducteur.

Le dispositif de contrôle de la valeur de la résistance de bruit étalon 4 utilise la modification de l'épaisseur de la couche résistance à partir d'une grille à contact Schottky dont on fait varier la tension appliquée.

L'amplificateur hyperfréquence 3 illustré à la figure 3 doit présenter une bande passante maximale et d'autre part être de conception aussi simple que possible.

La solution envisagée pour atteindre cet objectif est d'utiliser un montage source commune et de relier le drain à la grille de l'étage suivant par une simple capacité de liaison. Un des facteurs les plus importants qui limite la bande passante de cette configuration est le fait que l'admittance d'entrée (capacitive) d'un étage donné dans la chaîne d'amplification devient lorsque la fréquence augmente plus grande que l'admittance de sortie (conductive) de l'étage précédent.

La fréquence de coupure est donc de la forme :

$$f_c = g_{di}/2\pi C_{di+1}$$

où $g_{di}$ est l'admittance de sortie de l'étage i et $C_{di+1}$ la capacité d'entrée de l'étage i + 1.

Pour augmenter $f_c$, il faut donc diminuer $C_{di+1}$ par rapport à $g_{di}$. La solution proposée par la présente invention est d'utiliser des transistors à effet de champ de dimension (la largeur) décroissante. De la sorte, la capacité d'entrée et la conductance de sortie étant proportionnelle à cette largeur, la fréquence de coupure pourra donc être augmentée.

**Revendications**

1. Procédé d'étalonnage et de contrôle d'adaptation d'impédance pour chaînes de réception faible bruit, trouvant notamment son application en thermographie microonde pour la mesure de température interne d'un corps, procédé dans lequel :

on capte le rayonnement thermique du corps à examiner à l'aide d'une antenne (1),

on compare le signal reçu (2) par l'antenne (1) avec le signal émis (5) par une source de bruit étalon (4), ajustable en température, caractérisé en ce que :

on dirige les signaux (2) reçus par l'antenne (1) et les signaux (5) issus de la source de bruit étalon (4) alternativement vers l'entrée d'un amplificateur (3) à travers des moyens de commutation (6), pilotés par une fréquence $F_0$,

on place, à l'entrée de l'amplificateur (3), alternativement et périodiquement à une fréquence $F_1$, une impédance additionnelle (15) en parallèle soit avec l'antenne (1), soit avec la source de bruit étalon (4), la fréquence $F_1$ étant nettement supérieure à la fréquence $F_0$,

on compare l'influence exercée par l'impédance additionnelle (15) sur l'antenne (1), et sur la source de bruit étalon (4), en détectant la modification du signal d'entrée (7) de l'amplificateur (3) et en analysant l'écart des impédances présentées respectivement par l'antenne (1) et la source de bruit étalon (4),

on ajuste, en adaptant leur impédance, soit l'antenne (1), soit la source de bruit (4) pour égaliser ces influences et par voie de conséquence égaliser les impédances présentées par l'antenne (1) et la source de bruit étalon (4).

2. Procédé d'étalonnage et de contrôle d'adaptation d'impédance selon la revendication 1, caractérisé par le fait que :

on détecte et on analyse la modification du signal d'entrée (7), lors de la comparaison de l'influence exercée par l'impédance additionnelle (15) placée périodiquement sur l'entrée (7) de l'amplificateur (3), par des moyens de détection synchrone (18) de fréquence F1, qui délivrent un signal (19), image de l'écart des impédances présentées respectivement par l'antenne (1) et la source de bruit étalon (4),

on ajuste l'adaptation d'impédance présentée par la source de bruit étalon (4) de sorte à égaliser l'impédance de la source de bruit étalon (4) avec celle présentée par l'antenne (1), par l'intermédiaire de moyens de contrôle (20) agissant sur la source de bruit étalon (4) en fonction dudit signal d'écart (19).

3. Procédé d'étalonnage et de contrôle d'adaptation d'impédance selon la revendication 1, caractérisé par le fait que l'on ajuste le signal de sortie (5) de la source de bruit étalon (4) par l'ajustement de la température de ladite source (4) par l'intermédiaire d'un circuit de commande de chauffage (13), commandé par des moyens de détection (10, 11) réagissant en fonction du signal de sortie (9) de l'amplificateur (3).

4. Dispositif de mesure de bruits microondes mettant en œuvre le procédé de l'une quelconque des revendications précédentes, comprenant au moins :

une antenne (1), apte à capter le rayonnement microonde, et à délivrer un signal de sortie (2) correspondant,

une source de bruit étalon (4), ajustable en température via un circuit de commande de chauffage (13), et apte à délivrer un signal (5) correspondant à la température de ladite source (4),

des moyens de commutation (6), pilotés par une fréquence $F_0$, dont les entrées sont reliées respectivement à ladite antenne (1) et à ladite source de bruit étalon (4), et délivrant un signal de sortie (7),

un amplificateur (3), dont l'entrée est au moins connectée à la sortie desdits moyens de commutation (6), délivrant en sortie (9) un signal d'amplitude correspondant à la différence de niveau entre lesdits signaux délivrés respectivement par l'antenne et par la source de bruit étalon,

une impédance additionnelle (15), apte à être placée périodiquement sur l'entrée de l'amplificateur (3) en parallèle avec l'impédance présentée soit par l'antenne, soit par la source de bruit à l'entrée de l'amplificateur,

des moyens de contrôle (14) d'adaptation d'impédance, pilotés à une fréquence $F_1$ nettement supérieure à ladite fréquence $F_0$, aptes au moins soit à placer ladite impédance (15) à l'entrée de l'amplificateur (3), soit se placer en circuit ouvert (16),

des moyens (18, 20) pour analyser l'écart des impédances présentées par l'antenne (1) et la source de bruit étalon (4) et pour ajuster, en adaptant leur impédance, soit l'antenne (1), soit la source de bruit (4), pour égaliser les influences exercées par l'impédance additionnelle (5) sur l'antenne (1) et sur la source de bruit (4), et par voie de conséquence pour égaliser les impédances présentées par l'antenne (1) et la source de bruit étalon (4).

5. Dispositif de mesure de bruits microondes selon la revendication 4, caractérisé par le fait que le signal (7) résultant en sortie de commutateur (6) est analysé au travers d'un détecteur synchrone (18) de fréquence $F_1$ qui, par l'intermédiaire d'un circuit de réglage (20) de l'adaptation d'impédance commandé par ledit détecteur (18), ajuste l'impédance de la source étalon (4).

6. Dispositif de mesure de bruits microondes selon la revendication 4, caractérisé par le fait qu'il est formé d'un circuit intégré monolithique, constitué de couches épitaxiées n + n sur semi-isolant réalisé en semi-conducteur du type III-V tel que AsGa.

7. Dispositif de mesure de bruits microondes selon la revendication 6, caractérisé par le fait que l'élément actif de base dudit circuit intégré monolithique est constitué de transistors à effet de champ utilisant une grille à contact Schottky.

8. Dispositif de mesure de bruits microondes selon la revendication 6, caractérisé par le fait que la source étalon (4) est formée par une résistance de bruit sous forme de couche résistante planar constituée d'une couche épitaxiée entre deux contacts ohmiques.

9. Dispositif de mesure de bruits microondes selon la revendication 8, caractérisé par le fait que l'ajustement du signal (5) de la source étalon (4) est réalisé à l'aide de résistances chauffantes encadrant ou disposées à proximité immédiate de la résistance de bruit (4) et que le contrôle de la valeur de la résistance de bruit (4) utilise les variations en fonction de la température de la caractéristique courant tension d'un contact métal semi-conducteur.

10. Dispositif de mesure de bruits microondes selon les revendications 8 ou 9, caractérisé par le fait que le moyen pour ajuster la source de bruit est un dispositif de contrôle (20) de la valeur de la résistance de bruit qui utilise la modification de l'épaisseur de la couche résistante à partir d'une grille à contact Schottky dont on fait varier la tension appliquée.

11. Dispositif de mesure de bruits microondes selon la revendication 6, caractérisé par le fait que l'amplificateur (3) est formé d'un montage en cascade de transistors à effet de champ à source commune dont les drains sont reliés à la grille de l'étage suivant par une capacité de liaison, les transistors à effet de champ étant de dimension décroissante.

## Claims

1. Process of calibration and impedance adaptation control for low-noise reception chains applied in particular in microwave thermography for measuring the internal temperature of a body, in which process :

the thermal radiation of the body to be examined is picked up with the aid of an aerial (1),

the signal (2) received by aerial (1) is compared with signal (5) emitted by a source of standard noise (4), the temperature of which is adjustable, characterised in that

signals (2) received by aerial (1) and signals (5) emitted by the source of standard noise (4) are directed alternately towards the input of an amplifier (3) through commutation means (6), controlled by a frequency $F_0$,

an additional impedance (15) in parallel either with aerial (1) or with the source of standard noise (4) is applied to the input of amplifier (3), alternately and periodically at a frequency $F_1$, said frequency $F_1$ being definitely higher than frequency $F_0$,

the effect of additional impedance (15) on aerial (1) is compared with that on the source of standard noise (4), by detecting the modification of input signal (7) of amplifier (3) and by analysing the difference between the impedances presented respectively by aerial (1) and source of standard noise (4),

in adapting their impedance either aerial (1) or source of noise (4) is adjusted with a view to equalising these effects and, as a result, equalising the impedances presented by aerial (1) and source of standard noise (4).

2. Process of calibration and impedance adaptation control according to claim 1, characterised in that

the modification of input signal (7) is, in the course of comparing the effect exercised by additional impedance (15) applied periodically to input (7) of amplifier (3), detected and analysed by means of synchronous detection (18) at frequency $F_1$, said means supplying a signal (19) representative of the difference between the impedances presented by aerial (1) and source of standard noise (4), respectively,

the adaptation of the impedance presented by source of standard noise (4) is adjusted in such a way as to equalise the impedance of source of standard noise (4) with that presented by aerial (1), with the aid of control means (20) acting on source of standard noise (4) as a function of said difference signal (19).

3. Process of calibration and impedance adaptation control according to claim 1, characterised in that output signal (5) of source of standard noise (4) is adjusted by adjusting the temperature of said source (4) with the aid of a heating control circuit (13), controlled by detection means (10, 11), reacting as a function of output signal (9) of amplifier (3).

4. Device for measuring microwave noise by means of the process specified in any of the preceding claims, comprising at least

an aerial (1), capable of picking up the microwave radiation and supplying a corresponding output signal (2),

a source of standard noise (4), the temperature of which can be adjusted by means of a heating control circuit (13) and which is capable of supplying a signal (5) corresponding to the temperature of said source (4),

commutation means (6), controlled by a frequency $F_0$, the inputs of which are connected to said aerial (1) and to said source of standard noise (4), respectively, and which deliver an output signal (7),

an amplifier (3), the input of which is at least connected to the output of said commutation means (6), supplying by way of output (9) a signal with an amplitude corresponding to the difference in level between said signals supplied by the aerial and the source of standard noise, respectively,

an additional impedance (15) which can be applied periodically to the input of amplifier (3) in parallel with the impedance presented either by the aerial or by the source of noise to the input of the amplifier,

means for impedance adaptation control (14) controlled at a frequency $F_1$ definitely higher than said frequency $F_0$, at least capable of applying said impedance (15) to the input of amplifier (3) or of going open-circuit (16),

means (18, 20) for analysing the difference between the impedances presented by aerial (1) and source of standard noise (4) and for adjusting, in the process of impedance adaptation, either aerial (1) or source of noise (4), so as to equalise the influences exerted by additional impedance (15) on aerial (1) and on source of noise (4) and, as a result equalise the impedances presented by aerial (1) and source of standard noise (4).

5. Device for measuring microwave noise according to claim 4, characterised in that signal (7) produced at the output of commutator (6) is analysed through a synchronous detector (18) at frequency $F_1$, which adjusts, via a circuit for regulating (20) the impedance adaptation controlled by said detector (18), the impedance of standard source (4).

6. Device for measuring microwave noise according to claim 4, characterised by the fact it is formed by a monolithic integrated circuit consisting of epitaxial layers n + n on semi-isolating material, made from semiconductor of type III-V such as AsGa.

7. Device for measuring microwave noise according to claim 6, characterised in that the active base element of said monolithic integrated circuit consists of field effect transistors utilising a Schottky contact grid.

8. Device for measuring microwave noise according to claim 6, characterised in that standard source (4) consists in a noise resistance in the form of a planar resistant layer constituted by an epitaxial layer between two ohmic contacts.

9. Device for measuring microwave noise according to claim 8, characterised in that adjustment of signal (5) of standard source (4) is brought about with the aid of heating resistances located about or in immediate proximity of noise resistance (4), and in that control of the level of noise resistance (4) is based on the variations in temperature function of the current/voltage characteristic of a semiconductor metal contact.

10. Device for measuring microwave noise according to claims 8 or 9, characterised in that the means for adjusting the source of noise consists in a device for controlling (20) the value of the noise resistance, which utilises modification of the thickness of the resistant layer on the basis of a Schottky contact grid, the applied voltage of which is caused to vary.

11. Device for measuring microwave noise according to claim 6, characterised in that amplifier (3) is formed by a cascade assembly of field effect transistors with a common source, the drains of which are connected to the grid of the following stage by a linking capacitor, the field effect transistors being of dimishing size.

**Patentansprüche**

1. Eich- und Kontrollverfahren zur Impedanzanpassung bei rauscharmen Empfangsketten, das insbesondere in der Mikrowellenthermographie angewendet wird, um die interne Temperatur eines Körpers zu messen, wobei bei diesem Verfahren :

die Wärmestrahlung des zu untersuchenden Körpers mittels einer Antenne (1) aufgefangen wird,

das über die Antenne (1) empfangene Signal (2) mit dem von einer Eichrauschquelle (4), deren Temperatur einstellbar ist, ausgesandten Signal (5) verglichen wird, dadurch gekennzeichnet, daß :

die über die Antenne (1) empfangenen Signale (2) und die von der Eichrauschquelle (4) ausgehenden Signale (5) über Umschaltmittel (6), die mit einer Frequenz $F_0$ gesteuert werden, abwechselnd auf den Eingang eines Verstärkers (3) gegeben werden,

an den Eingang des Verstärkers (3) mit einer Frequenz $F_1$ abwechselnd und periodisch eine zusätzliche Impedanz (15) angeschlossen wird, und zwar parallel zu entweder der Antenne (1), oder der Eichrauschquelle (4), wobei die Frequenz $F_1$ wesentlich größer als die Frequenz $F_0$ ist,

der Einfluß, der von der zusätzlichen Impe-

danz (15) einerseits auf die Antenne (1), und andererseits auf die Eichrauschquelle (4) ausgeübt wird, miteinander verglichen wird, wozu die Änderung des Eingangssignals (7) des Verstärkers (3) nachgewiesen wird, und die Abweichung der Impedanzen von einerseits der Antenne (1), und andererseits der Eichrauschquelle (4) analysiert wird,

entweder die Antenne (1), oder die Eichrauschquelle (4) durch Anpassung ihrer Impedanz eingestellt wird, um diese Einflüsse gleich zu machen, und folglich die Impedanz der Antenne (1) und der Eichrauschquelle (4) gleich zu machen.

2. Eich- und Kontrollverfahren zur Impedanzanpassung gemäß Anspruch 1, dadurch gekenzeichnet, daß :

bei dem Vergleich des Einflusses, der von der zusätzlichen Impedanz (15) ausgeübt wird, die periodisch an den Eingang des Verstärkers (3) angeschlossen wird, die Änderung des Eingangssignals (7) nachgewiesen und analysiert wird, und zwar durch mit der Frequenz $F_1$ gesteuerte Mittel (18) zum synchronen Nachweis, die ein Signal (19) liefern, das repräsentativ ist für die Abweichung der Impedanzen von einerseits der Antenne (1) und andererseits der Eichrauschquelle (4),

die Impedanzanpassung der Eichrauschquelle (4) so vorgenommen, wird, daß die Impedanz der Eichrauschquelle (4) gleich der Impedanz der Antenne (1) gemacht wird, und zwar durch Kontrollmittel (20), die in Abhängigkeit von dem besagten Abweichungssignal (19) auf die Eichrauschquelle (4) einwirken.

3. Eich- und Kontrollverfahren zur Impedanzanpassung gemäß Anspruch 1, dadurch gekennzeichnet, daß das Ausgangssignal (5) der Eichrauschquelle (4) über die Temperatur der besagten Eichrauschquelle (4) eingestellt wird, und zwar mittels einer Heizsteuerschaltung (13), die durch Nachweismittel (10, 11) gesteuert wird, die auf das Ausgangssignal (9) des Verstärkers (3) ansprechen.

4. Vorrichtung zur Messung des Mikrowellenrauschens, bei der das Verfahren von irgendeinem der vorhergehenden Ansprüche verwirklicht wird, aus mindestens :

einer Antenne (1), die geeignet ist, die Mikrowellenstrahlung aufzufangen und ein entsprechendes Ausgangssignal (2) zu liefern,

einer Eichrauschquelle (4), deren Temperatur über eine Heizsteuerschaltung (13) einstellbar ist, und die ein Signal (5) liefern kann, das der Temperatur der besagten Eichrauschquelle (4) entspricht,

mit einer Frequenz $F_0$ gesteuerten Umschaltmitteln (6), deren Eingänge mit der besagten Antenne (1) bzw. mit der besagten Eichrauschquelle (4) verbunden sind, und die ein Ausgangssignal (7) liefern,

einem Verstärker (3), dessen Eingang mindestens mit dem Ausgang der besagten Umschaltmittel (6) verbunden ist, und dessen Ausgang (9) ein Signal mit einer Amplitude liefert, die der Niveaudifferenz zwischen den besagten Signalen entspricht, die von der Antenne (1) bzw. der Eichrauschquelle (4) geliefert werden,

einer zusätzlichen Impedanz (15), die periodisch an den Eingang des Verstärkers angeschlossen werden kann, und zwar parallel zu der Impedanz der Antenne (1) bzw. der Eichrauschquelle (4),

Kontrollmitteln (14) zur Impedanzanpassung, die mit einer Frequenz $F_1$ gesteuert werden, die wesentlich höher als die besagte Frequenz $F_0$ ist, und über die mindestens zwischen der besagten Impedanz (15) und dem Eingang des Verstärkers (3) eine Verbindung bzw. eine Unterbrechung (16) hergestellt werden kann,

Mitteln (18, 20) zum Analysieren der Abweichung zwischen den Impedanzen von einerseits der Antenne (1), und andererseits der Eichrauschquelle (4), und zum Einstellen von entweder der Antenne (1) oder der Eichrauschquelle (4) durch Anpassung ihrer Impedanz, um die Einflüsse gleich zu machen, die von der zusätzlichen Impedanz (15) auf die Antenne (1) und auf die Eichrauschquelle (4) ausgeübt werden, und um folglich die Impedanzen von einerseits der Antenne (1), und andererseits der Eichrauschquelle (4) gleich zu machen.

5. Vorrichtung zur Messung des Mikrowellenrauschens gemäß Anspruch 4, dadurch gekennzeichnet, daß das Signal (7), das am Ausgang des Umschalters (6) erhalten wird, in einem mit der Frequenz $F_1$ gesteuerten synchronen Detektor (18) analysiert wird, der über eine Steuerschaltung (20) zur Impedanzanpassung, die durch den besagten Detektor (18) gesteuert wird, die Impedanz der Eichrauschquelle (4) einstellt.

6. Vorrichtung zur Messung des Mikrowellenrauschens gemäß Anspruch 4, dadurch gekennzeichnet, daß sie aus einer monolithischen integrierten Schaltung besteht, die Epitaxieschichten vom Typ n+/n auf halbisolierendem Halbleitermaterial vom Typ III-V, wie beispielsweise GaAs aufweist.

7. Vorrichtung zur Messung des Mikrowellenrauschens gemäß Anspruch 6, dadurch gekennzeichnet, daß das aktive Grundelement der besagten monolithischen integrierten Schaltung aus Feldeffekttransistoren besteht, die ein Schottky-Kontaktgate aufweisen.

8. Vorrichtung zur Messung des Mikrowellenrauschens gemäß Anspruch 6, dadurch gekennzeichnet, daß die Eichrauschquelle (4) aus einem Rauschwiderstand in Form einer planaren Widerstandsschicht besteht, die von einer zwischen zwei Ohmschen Kontakten angeordneten Epitaxieschicht gebildet wird.

9. Vorrichtung zur Messung des Mikrowellenrauschens gemäß Anspruch 8, dadurch gekennzeichnet daß die Einstellung des Signals (5) der Eichrauschquelle (4) mittels Heizwiderständen verwirklicht wird, die den Rauschwiderstand (4) umgeben oder in unmittelbarer Nähe des Rauschwiderstandes (4) angeordnet sind, und daß zur Kontrolle des Wertes des Rauschwiderstandes (4) die Veränderung der Strom/Spannungs-Kennlinie eines Metall/Halbleiter-Kontakts in Abhängigkeit von der Temperatur benutzt wird.

10. Vorrichtung zur Messung des Mikrowellenrauschens gemäß Anspruch 8 oder 9, dadurch gekennzeichnet, daß das Mittel zum Einstellen der Eichrauschquelle (4) eine Vorrichtung (20) zur Kontrolle des Wertes des Rauschwiderstandes ist, bei der die Änderung der Dicke der Widerstandsschicht über ein Schottky-Kontaktgate benutzt wird, bei dem die angelegte Spannung variiert wird.

11. Vorrichtung zur Messung des Mikrowellenrauschens gemäß Anspruch 6, dadurch gekennzeichnet, daß der Verstärker (3) aus einer Kaskadenschaltung von Feldeffekttransistoren mit gemeinsamer Source besteht, deren Drains über eine Verbindungskapazität mit dem Gate der folgenden Stufe verbunden sind, wobei die Feldeffekttransistoren geringer werdende Abmessungen aufweisen.

# FIG 1

| Bloc | Texte |
|------|-------|
| 38,2 | Indicateur |
| 8 | GENERATEUR BF (Fo) |
| 11 | DETECTION SYNCHRONE (Fo) |
| 12, 13 | COMMANDE DE CHAUFFAGE |
| 17 | GENERATEUR BF F1 ≫ Fo |
| 10 | DETECTEUR |
| 9 | |
| 18, 19 | DETECTION SYNCHRONE F1 ≫ Fo |
| 3 | AMPLIFICATEUR G = 30dB B = 1 à 3 GHz F = 4dB |
| 16, 15, 14 | CONTROLE DE L'ADAPTATION CO 50 Ω |
| 6 | COMMUTATEUR A 2 VOIES |
| 5, 4 | RESISTANCE DE BRUIT ETALON |
| 2 | |
| 1 | ANTENNE |
| 20 | REGLAGE DE L'ADAPTATION |

FIG 2

1

FIG 3

3

4

1